# EUROPEAN PATENT SPECIFICATION

(11) **EP 0 320 540 B1**
(45) Date of publication and mention of the grant of the patent: **08.09.1993**
(21) Application number: 87310961.5
(22) Date of filing: 14.12.1987
(51) Int. Cl.: H03F 3/30

(54) **An audio amplifier**
Tonfrequenzverstärker
Amplificateur audio

(43) Date of publication of application: 21.06.1989
(73) Proprietor: SEGAL, Brahm, Torrance, CA 90501 (US)
(72) Inventor: SEGAL, Brahm, Torrance, CA 90501 (US)
(74) Representative: Coxon, Philip

(56) References cited:
- US-A- 3 995 228
- US-A- 4 528 520
- US-A- 4 555 672
- TECHNISCHE MITTEILUNGEN KRUPP; FORSCHUNGSBERICHTE, vol. 31, no. 1, June 1973, Essen, DE; P. ERDMANN: "Spezialverstärker für Forschungszwecke"

## Description

This invention relates to an audio amplifier and, in particular, to semiconductor transformerless audio amplifiers. More particularly, this invention relates to such an audio amplifier having a high power and relatively high voltage output.

In U.S. Patent No. 4,555,672 a transformerless semiconductor audio amplifier is described in which the positive and negative outputs of an operational amplifier are employed to drive two oppositely phased current mirror circuits which provide a balanced high-power output and positive and negative mirror-image waveforms with respect to ground. In this system distortion is minimized and high fidelity and stability is afforded by providing negative feedback, temperature compensation, and means for eliminating spurious high frequency oscillations.

The output of the amplifier described in U.S. Patent No. 4,555,672 has a high current, low voltage output which is adequate for applications in which a small number of loudspeakers need be driven and where the feeder lines to such loudspeakers are relatively short in length. In situations, however, where a large number of speakers must be driven, it is necessary to employ a step-up transformer to raise the voltage so that these multiple outlets can, in effect, be impedance-matched to the output of the amplifier and further, so that the power can be distributed at higher voltage and lower current to minimize "IR" losses in the feeder lines. The need for such transformers not only adds to the expense of the system, but also in themselves, contribute to losses, and sometimes contribute to distortion.

The audio amplifier system of the present invention is a modification of that of U.S. Patent No. 4,555,672, whereby a relatively high-voltage, high-impedance output is provided for distribution to multiple loudspeaker outlets without the aforementioned shortcomings. Except for the modifications, to the current and power amplifier stages of the amplifier system, the amplifier of the present invention is basically the same as that of U.S. Patent No, 4,555,672 and the disclosure of that patent is incorporated herein by reference.

In US-A-3995228 there is disclosed an amplifier circuit having high power output capability.

It is an object of this invention to provide a transformerless semiconductor audio amplifier suitable for driving multiple loudspeaker outlets which may be at a distance from the amplifier.

It is a further object of this invention to provide a transformerless semi-conductor audio amplifier which has a relatively high voltage output signal.

According to one aspect of this invention there is provided an audio amplifier as defined in the claims appended hereto. The amplifier is preferably a semiconductor transformerless audio amplifier and may comprise:
a power source having positive and negative terminals providing equal positive and negative voltages with respect to a reference source.

The amplifier may also comprise an output terminal.

An input signal source may be provided. Voltage amplifier means may be connected between the positive and negative terminals of the power source for receiving said input signal and generating a pair of outputs in phase opposition in response thereto,
Separate current amplifier means may also be provided for respectively amplifying each of the outputs of said voltage amplifier means.

A voltage divider may be provided, being formed of equal value resistors connected in series between the positive terminal and the output terminal and between the negative terminal and the output terminal.

The amplifier may comprise a first set of cascaded transistors connected with the emitter of the output transistor of the cascade coupled to the output terminal and with the base of the input transistor of the cascade driven by one of said current amplifier means.

The amplifier may also comprise a second set of cascaded transistors connected with the emitter of the output transistor of the cascade coupled to the output terminal and with the base of the input transistor of the cascade driven by the other of said current amplifier means.

The amplifier may comprise a third set of cascaded transistors with the emitter of the output transistor of the cascade connected to the collectors of said first set of cascaded transistors and the collectors of said third set of transistors coupled to the positive power terminal, the base of the input transistor of the cascade of the third set of transistors being connected to a portion of the voltage divider between the positive terminal and output terminal.

The amplifier may comprise a fourth set of cascaded transistors with the emitter of the output transistor of the cascade connected to the collectors of said second set of cascaded transistors and the collectors of said fourth set of cascaded transistors coupled to the negative power terminal, the base of the input transistor of the cascade of the fourth set of transistors being connected to a portion of the voltage divider between the negative terminal and output terminal.

According to another aspect of this invention there is provided an audio amplifier which may comprise:
an input amplifier having inverting and non-inverting inputs, positive and negative bias ports and an output, the non-inverting input being a signal input.

The amplifier may comprise a positive potential source having positive and reference terminals.

A negative potential source may be provided having a negative terminal and a reference terminal common with that of said positive potential source.

The amplifier may comprise a first current amplifier having an input coupled between the positive bias port of said input amplifier and said positive terminal and having a first current amplified output.

A second current amplifier may be provided having an input coupled between the negative bias port of the input amplifier and said negative terminal and having a second current amplified output.

The amplifier may comprise an amplifier output terminal.

The amplifier may comprise a first transistor amplifying circuit comprising a first plurality of transistors connected in cascaded configuration, a first emitter resistor connected between the emitter of the output transistor of said first plurality of transistors and the amplifier output terminal, the output of said first current amplifier being fed as an input to said first transistor amplifying circuit.

Said first transistor amplifying circuit may further include a second plurality of transistors connected in cascaded configuration between said positive terminal and the collectors of the first plurality of transistors.

The amplifier may comprise a second transistor amplifying circuit comprising a third plurality of transistors of opposite polarity to the transistors of said first amplifying circuit and including a third plurality of transistors connected in a cascaded configuration, a second emitter resistor connected between the emitter of the output transistor of said third plurality of transistors and the amplifier output terminal, the output of said second current amplifier being fed as an input to said second transistor amplifying circuit.

Said second transistor amplifying circuit may further include a fourth plurality of transistors connected in cascaded configuration between said negative terminal and the collectors of said third plurality of transistors.

A resistor divider network may be provided comprising a plurality of equal value resistors connected between the amplifier output terminal and said negative potential source and between said amplifier output terminal and said positive potential source, the input to said second plurality of cascaded transistors being connected to a portion of said divider network between the positive potential source and the amplifier output terminal, the input to said fourth plurality of transistors being connected to a portion of said divider between the negative potential source and the amplifier output terminal.

The amplifier may comprise a first power amplifier connected to deliver current between the positive potential source and the amplifier output terminal, and may also comprise a second power amplifier connected to deliver current between the negative potential source and the amplifier output terminal.

Said first and second power amplifiers may each comprise a separate amplifier stage driven by a separate output of one of the first through fourth plurality of cascaded transistors.

A negative feedback circuit connected between the amplifier output terminal and the inverting input of the input amplifier may be provided.

A plurality of capacitors of different capacitances may be provided each separately connected between the negative and reference terminals and between the positive and reference terminals.

Reference is now made to the accompanying drawings in which:-
Figure 1 is a schematic drawing of a preferred embodiment of the invention;
Figure 2 is a schematic drawing illustrating a cascaded "Darlington" circuit employed in the amplifier and incorporating NPN transistors, and
Figure 3 is a schematic drawing illustrating a cascaded "Darlington" circuit employed in the power amplifier utilizing PNP transistors.

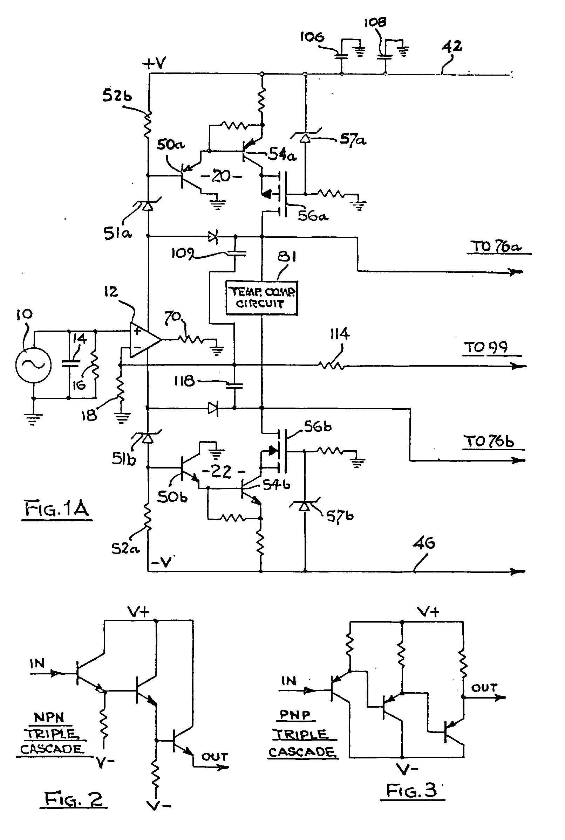

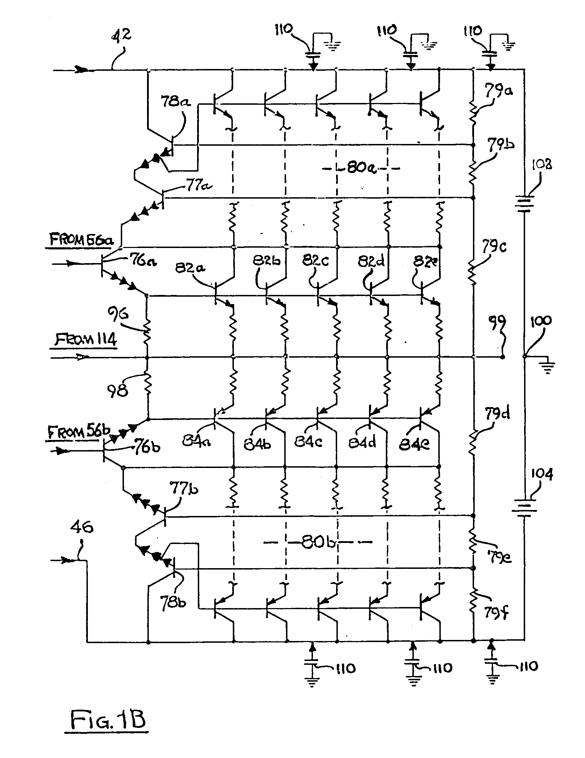

Referring now to Figures 1A and 1B, a preferred embodiment of the invention is schematically illustrated. A source of audio frequency signals 10 is applied between the positive or non-inverting input of operational amplifier 12 and ground across a small capacitor 14 which may be of the order of 30 PF and resistor 16. The inverting input of the amplifier is connected between resistor 18 and ground. Operational amplifier 12 functions as a voltage amplifier and its oppositely phased outputs are fed to drive the current amplifiers 20 and 22 in mirror image fashion. Amplifiers 20 and 22 are identical and include similar transistors 50 which are driven by the respective positive and negative outputs of amplifier 12 through Zener diodes 51a and 51b which are connected to the positive and negative busses 42 and 46 through an associated resistor 52a and 52b. Transistors 50a and 50b drive associated transistors 54a and 54b which are connected therewith in a "Darlington" configuration. The outputs of transistors 54a and 54b drive associated POWER MOSFETs 56a and 56b. Zener diodes 57a and 57b provide bias for the POWER MOSFETs. POWER MOSFETs 56a and 56b operate to reduce the voltage stress placed on transistors 50 and 54.

The outputs of POWER MOSFETs 56a and 56b are fed to cascaded transistor circuits 76a and 76b, respectively. These circuits each comprise three transistors connected in cascaded "Darlington" configuration as shown in Figures 2 and 3, respectively, the three arrows each representing one of the transistors in the cascade. Connected between the collectors of the transistors of the triple cascaded circuit 76a and positive voltage bus 42 are first and second triple cascaded transistor circuits 77a and 78a, each of these circuits being as shown in Figure 2. Similarly, connected between the collectors of the cascaded transistors 76b and the negative voltage bus 46, are cascaded transistor circuits 77b and 78b which are connected as shown in Figure 3. Six identical resistors, 79a - 79f, are connected between the positive voltage bus 42 and the negative voltage bus 46, with the juncture between resistor 79c and 79d being connected to output terminal 99. Resistors 79a - 79f provide a voltage divider from the output line providing equal drive for each of the cascaded transistor circuits 77a, 78a, 77b and 78b. Such drive from the output results in higher linearity.

An analysis will readily show that the transistors in the cascaded circuits 76a, 77a and 78a will equally share the voltage for any output signal during the positive half cycles, while the same will be true for cascaded stages 76b, 77b and 78b during the negative half cycles. so also the transistors will share power dissipation. In this manner a high voltage output is provided without exceeding the breakdown voltages or power dissipation ratings of the transistors.

The outputs of the cascaded circuits 76a and 76b are fed to paralleled power transistors 82a - 82e and 84a -84e, respectively as in the system of U.S. Patent No. 4,555,672. The outputs of cascaded stages 77a, 78a and 77b and 78b are also fed to similar paralleled power transistors which are only partially shown in Figure 1 for convenience of illustration.

As in the device of U.S. Patent No. 4,555,672 various capacitors 110 are selectively connected at various points between both the positive and negative power busses 42 and 46 and ground to eliminate any spurious high frequency oscillations which may arise. Also, as in U.S. Patent No. 4,555,672 negative feedback is provided from the output terminal 99 through resistor 114 to the inverting input of operational amplifier 12. Still further as in the system of U.S. Patent No. 4,555,672, harmonic distortion is minimized by means of feedback capacitors 109 and 118 which provide negative feedback to the inverting input of operational amplifier 12. Temperature compensating circuit 81 is also employed, as in the system of U.S. Patent No. 4,555,672, between the inputs to transistor circuits 76a and 76b. this circuit operates as a current regulator to provide DC stability to the system with variations in temperature. As all of these just-mentioned circuits are described in detail in U.S. Patent No. 4,555,672, the disclosure of such circuits is supplemented by the incorporation of the disclosure of U.S. Patent No. 4,555,672 into the present application by reference thereto.

## Claims

1. A semiconductor transformerless audio amplifier comprising:
a power source having positive (42) and negative (46) terminals providing equal positive and negative voltages with respect to a reference source,
an output terminal (99),
an input signal source (10),
voltage amplifier means (12) connected between the positive (42) and negative (46) terminals of the power source for receiving said input signal and generating first and second outputs in phase opposition in response to said input signal,
separate current amplifier means (20,22) for respectively amplifying each of the first and second outputs of said voltage amplifier means (12),
a voltage divider (79a-79f) formed of equal value resistors connected in series between the positive terminal (42) and the output terminal (99) and between the negative terminal (46) and the output terminal (99),
a first set of cascaded transistors (76a) connected with the emitter of the output transistor of the cascade coupled to the output terminal (99) and with the base of the input transistor of the cascade driven by one of said current amplifier means (20),
a second set of cascaded transistors (76b) connected with the emitter of the output transistor of the cascade coupled to the output terminal (99) and with the base of the input transistor of the cascade driven by the other of said current amplifier means (22),
a third set of cascaded transistors (77a) with the emitter of the output transistor of the cascade connected to the collectors of said first set of cascaded transistors (76a) and the collectors of said third set of transistors coupled to the positive terminal (42), the base of the input transistor of the cascade of the third set of transistors being connected to a portion (79b,79e) of the voltage divider (79a-79f) between the positive terminal (42) and output terminal (99), and
a fourth set of cascaded transistors (77b) with the emitter of the output transistor of the cascade connected to the collectors of said second set of cascaded transistors (76b) and the collectors of said fourth set of cascaded transistors (77b) coupled to the negative terminal (46), the base of the input transistor of the cascade of the fourth set of transistors being connected to a portion (79d,79e) of the voltage divider (79a-79f) between the negative terminal (46) and output terminal (99), and characterised in that each of said current amplifier means (20,22) includes first (50a, 50b) and second (54a,54b) transistors connected in cascade and a power semi-conductor means (56a,56b) connected in cascade with said second transistor (54a,54b) to reduce the voltage stress on said first (50a, 50b) and second (54a,54b) transistors.

2. An amplifier according to Claim 1 further including fifth and sixth sets of cascaded transistors (78a,78b), the collectors of the transistors of said fifth set (78a) being connected to the positive terminal (42), the collectors of the transistors of said sixth set (78b) being connected to the negative terminal (46), the emitter of the input transistor of the fifth set (78a) being connected to the collectors of the transistors of the third set (77a), the emitter of the input transistor of the sixth set (78b) being connected to the collectors of the transistors of the fourth set (77b), the base of the input transistor of the fifth set (78a) being connected to a portion (79a,79b) of the voltage divider (79a-79f) between the positive terminal (42) and the portion of the divider (79b,79c) to which the base of the input transistor of the third set of transistors (77a) is connected, the base of the input transistor of the sixth set of transistors (78b) being connected to a portion (79e,79f) of the divider (79a-79f) between the negative terminal (46) and the portion of the divider (79d,79e) to which the base of the input transistor of the fourth set of transistors (77b) is connected.

3. An amplifier according to claim 1, wherein said voltage amplifier means (12) has inverting and noninverting inputs, and a third output, the non-inverting input being coupled to said input signal source (10), and said first and second outputs being provided by first and second input ports for the supply current to said voltage amplifier means
said first set of cascaded transistors (76a) being coupled to said output terminal (99) via a first emitter resistor (96) said second set of cascaded transistors (76b) being coupled to said output terminal (99) via a second emitter resistor (98) and wherein said amplifier further comprises
a first power amplifier (80a) connected to deliver current between the positive terminal (42) and the amplifier output terminal (99),
a second power amplifier (80b) connected to deliver current between the negative terminal (46) and the amplifier output terminal (99),
said first and second power amplifiers (80a,80b) each comprising a separate amplifier stage driven by a separate output of one of the first through fourth plurality of cascaded transistors (76a,76b,77a,77b),
a negative feedback circuit connected between the amplifier output terminal (99) and the inverting input of the input amplifier (12), and
a plurality of capacitors (106,108,110) of different capacitances each separately connected between the negative (46) and reference terminals (100) and between the positive (42) and reference terminals (100).

## Patentansprüche

1. Transformsatorloser Halbleiter-Tonfrequenzverstärker mit einer Versorgungsquelle mit positiven (42) und negativen (46) Anschlüssen zum Liefern gleicher positiver und negativer Spannung in bezug auf eine Referenzquelle,
einem Ausgangsanschluß (99),
einer Eingangssignalquelle (10),
einer Spannungsverstärkerschaltung (12), die zwischen den positiven und negativen Anschluß (42,46) der Versorgungsquelle geschaltet ist, zum Empfangen des Eingangssignales und zum Erzeugen erster und zweiter Ausgangssignale entgegengesetzter Phase in Antwort auf das Eingangssignal,
getrennte Stromverstärkerschaltungen (20,22) zum Verstärken des ersten bzw. zweiten Ausgangssignales der Spannungsverstärkerschaltung (12),
einem Spannungsteiler (79a - 79f) aus Widerständen gleicher Werte, die in Serie zwischen den positiven Anschluß (42) und den Ausgangsanschluß (99) und zwischen den negativen Anschluß (46) und den Ausgangsanschluß (99) geschaltet sind,
einem ersten Satz von Transistoren (76a) in Kaskadeschaltung, wobei der Emitter des Ausgangstransistors der Kaskade mit dem Ausgangsanschluß (99) verbunden ist und die Basis des Eingangstransistors von einer der Stromverstärkungsschaltungen (20) angesteuert wird,
einem zweiten Satz von Transistoren (76b) in Kaskadeschaltung, wobei der Emitter des Ausgangstransistors der Kaskade mit dem Ausgangsanschluß (99) verbunden ist und die Basis des Eingangstransistors von der anderen Stromverstärkungsschaltung (22) angesteuert wird,
einem dritten Satz von Transistoren (77a) in Kaskadeschaltung, wobei der Emitter des Ausgangstransistors der Kaskade mit den Kollektoren des ersten Satzes der in Kaskade geschalteten Transistoren (76a) verbunden ist, die Kollektoren des dritten Satzes von Transistoren an den positiven Anschluß (42) angeschlossen sind und die Basis des Eingangstransistors der Kaskade des dritten Satzes von Transistoren mit einem Teil (79b,79e) des Spannungsteilers (79a-79f) zwischen dem positiven Anschluß (42) und dem Ausgangsanschluß (99) verbunden ist, und
einem vierten Satz von Transistoren (77b) in Kaskadeschaltung, wobei der Emitter des Ausgangstransistors der Kaskade mit den Kollektoren des zweiten Satzes der in Kaskade geschalteten Transistoren (76b) verbunden ist, die Kollektoren des vierten Satzes der in Kaskade geschalteten Transistoren (77b) an den negativen Anschluß (46) angeschlossen sind und die Basis des Eingangstransistors der Kaskade des vierten Satzes der Transistoren mit einem Teil (79d,79e) des Spannungsteilers (79a bis 79f) zwischen dem negativen Anschluß (46) und dem Ausgangsanschluß (99) verbunden ist, und
dadurch gekennzeichnet, daß beide
Stromverstärkerschaltungen (20,22) je einen ersten (50a,50b) und einen zweiten (54a,54b) Transistor, in Kaskade geschaltet, und ein Leistungs-Halbleiterelement (56a,56b) aufweisen, das in Kaskade mit dem jeweils zweiten Transistor ((54a,54b) geschaltet ist, um die Spannungsbelastung an den ersten (50a,50b) und zweiten (54a,54b) Transistoren zu verringern.

2. Verstärker nach Anspruch, 1 mit einem fünften und sechsten Satz von in Kaskade geschalteten Transistoren (78a,78b), wobei die Kollektoren der Transistoren des fünften Satzes (78a) mit dem positiven Anschluß ((42) verbunden sind, die Kollektoren der Transistoren des sechsten Satzes (78b) mit dem negativen Anschluß (46) verbunden sind, der Emitter des Eingangstransistors des fünften Satzes (78a) mit den Kollektoren der Transistoren des dritten Satzes (77a) verbunden ist, der Emitter des Eingangstransistors des sechsten Satzes (78b) mit den Kollektoren der Transistoren des vierten Satzes (77b) verbunden ist, die Basis des Eingangstransistors des fünften Satzes (78a) mit einem Teil (79a,79b) des Spannungsteilers (79a-79f) zwischen dem positiven Anschluß (42) und dem mit der Basis des Eingangstransistors des dritten Satzes von Transistoren (77a) verbundenen Teil (79b,79c) des Spannungsteilers verbunden ist, und die Basis des Eingangstransistors des sechsten Transistorsatzes (78b) mit einem Teil (79e,79f) des Spannungsteilers (79a-79f) zwischen dem negativen Anschluß (46) und dem mit der Basis des Eingangstransistors des vierten Satzes von Transistoren (77b) verbundenen Teil des Spannungsteilers (79d,79e) verbunden ist.

3. Verstärker nach Anspruch 1, bei dem die Spannungsverstärkerschaltung (12) einen invertierenden und einen nicht-invertierenden Eingang und einen dritten Ausgang aufweist, wobei der nicht-invertierende Eingang mit der Eingangssignalquelle (10) verbunden ist und der erste und zweite Ausgang mit einem ersten und einem zweiten Eingangstor zur Stromzufuhr zur Spannungsverstärkerschaltung versehen sind,
wobei der erste Satz von in Kaskade geschalteten Transistoren (76a) an den Ausgangsanschluß (99) über einen ersten Emitterwiderstand (96) angeschlossen ist, der zweite Satz von in Kaskade geschalteten Transistoren (76b) an den Ausgangsanshluß (99) über einen zweiten Emitterwiderstand (98) angeschlossen ist und der Verstärker ferner
einen ersten Leistungsverstärker (80a), der zur Stromlieferung zwischen den positiven Anschluß (42) und den Ausgangsanschluß (99) des Verstärkers geschaltet ist, und
einen zweiten Leistungsverstärker (80b) aufweist, der zur Stromlieferung zwischen den negativen Anschluß (46) und den Ausgangsanschluß (99) des Verstärkers geschaltet ist,
wobei der erste und zweite Leistungsverstärker (80a,80b) je eine separate Verstärkerstufe aufweisen, die von einem separaten Ausgang eines der mehreren Transistoren in den vier Kaskadentransistorsätzen (76a,76b,77a,77b) angesteuert wird, und der Verstärker
eine negative Rückkopplungsschaltung, die zwischen den Ausgangsanschluß (99) des Verstärkers und den invertierenden Eingang des Eingangsverstärkers (12) geschaltet ist, und
mehrere Kondensatoren (106,108,110) verschiedener Kapazitätswerte aufweist, die jeweils zwischen den negativen (46) und den Referenzanschluß (100) sowie zwischen den positiven (42) und den Referenzanschluß (100) geschaltet sind.

## Revendications

1. Amplificateur audio sans transformateur et à semiconducteur, comprenant :
une source d'énergie ayant des bornes positive (42) et négative (46) fournissant des tensions positive et négative égales par rapport à une source de référence,
une borne de sortie (99),
une source de signaux d'entrée (10),
un moyen amplificateur de tension (12) connecté entre les bornes positive (42) et négative (46) de la source d'énergie pour recevoir ledit signal d'entrée et pour émettre des première et seconde sorties en opposition de phase en réponse audit signal d'entrée,
des moyens amplificateurs de courant distincts (20, 22) pour amplifier respectivement chacune des première et seconde sorties dudit moyen amplificateur de tension (12),
un diviseur de tension (79a à 79f) formé de résistances d'égale valeur montées en série entre la borne positive (42) et la borne de sortie (99) et entre la borne négative (46) et la borne de sortie (99),
un premier ensemble de transistors montés en cascade (76a), l'émetteur du transistor de sortie de la cascade étant connecté à la borne de sortie (99) et la base du transistor d'entrée de la cascade étant commandée par l'un desdits moyens amplificateurs de tension (20),
un deuxième ensemble de transistors montés en cascade (76b), l'émetteur du transistor de sortie de la cascade étant connecté à la borne de sortie (99) et la base du transistor d'entrée de la cascade étant commandée par l'autre desdits moyens amplificateurs de tension (22),
un troisième ensemble de transistors montés en cascade (77a), l'émetteur du transistor de sortie de la cascade étant connecté aux collecteurs dudit premier ensemble de transistors montés en cascade (76a) et les collecteurs dudit troisième ensemble de transistors étant connectés à la borne positive (42), la base du transistor d'entrée de la cascade du troisième ensemble de transistors étant connectée à une partie (79b, 79e) du diviseur de tension (79a à 79f) entre la borne positive (42) et la borne de sortie (99), et
un quatrième ensemble de transistors montés en cascade (77b), l'émetteur du transistor de sortie de la cascade étant connecté aux collecteurs dudit deuxième ensemble de transistors montés en cascade (76b) et les collecteurs dudit quatrième ensemble de transistors montés en cascade (77b) étant connectés à la borne négative (46), la base du transistor d'entrée de la cascade du quatrième ensemble de transistors étant connectée à une partie (79d, 79e) du diviseur de tension (79a à 79f) entre la borne négative (46) et la borne de sortie (99), et caractérisé en ce que chacun desdits moyens amplificateurs de courant (20, 22) comprend des premiers (50a, 50b) et des seconds (54a, 54b) transistors montés en cascade et un moyen à semiconducteur de puissance (56a, 56b) connecté en cascade avec ledit second transistor (54a, 54b) pour réduire la contrainte galvanique sur lesdits premiers (50a, 50b) et seconds (54a, 54b) transistors.

2. Amplificateur selon la revendication 1, comprenant en outre des cinquième et sixième ensembles de transistors montés en cascade (78a, 78b), les collecteurs des transistors dudit cinquième ensemble (78a) étant connectés à la borne positive (42), les collecteurs des transistors dudit sixième ensemble (78b) étant connectés à la borne négative (46), l'émetteur du transistor d'entrée du cinquième ensemble (78a) étant connecté aux collecteurs des transistors du troisième ensemble (77a), l'émetteur du transistor d'entrée du sixième ensemble (78b) étant connecté aux collecteurs des transistors du quatrième ensemble (77b), la base du transistor d'entrée du cinquième ensemble (78a) étant connectée à une partie (79a, 79b) du diviseur de tension (79a à 79f) entre la borne positive (42) et la partie du diviseur (79b, 79c) à laquelle est connectée la base du transistor d'entrée du troisième ensemble de transistors (77a), la base du transistor d'entrée du sixième ensemble de transistors (78b) étant connectée à une partie (79e, 79f) du diviseur (79a à 79f) entre la borne négative (46) et la partie du diviseur (79d, 79e) à laquelle est connectée la base du transistor d'entrée du quatrième ensemble de transistors (77b).

3. Amplificateur selon la revendication 1, dans lequel ledit moyen amplificateur de tension (12) a des entrées inverseuse et non inverseuse, et une troisième sortie, l'entrée non inverseuse étant reliée à ladite source de signaux d'entrée (10), et lesdites première et seconde sorties étant constituées par des première et seconde entrées pour le courant d'alimentation audit moyen amplificateur de tension
ledit premier ensemble de transistors montés en cascade (76a) étant connecté à ladite borne de sortie (99) par l'intermédiaire d'une première résistance d'émetteur (96), ledit deuxième ensemble de transistors montés en cascade (76b) étant connecté à ladite borne de sortie (99) par l'intermédiaire d'une seconde résistance d'émetteur (98), et dans lequel ledit amplificateur comprend en outre
un premier amplificateur de puissance (80a) connecté pour fournir du courant entre la borne positive (42) et la borne de sortie (99) de l'amplificateur,
un second amplificateur de puissance (80b) connecté pour fournir du courant entre la borne négative (46) et la borne de sortie (99) de l'amplificateur,
lesdits premier et second amplificateurs de puissance (80a, 80b) comprenant chacun un étage amplificateur distinct commandé par une sortie distincte de l'une de la première à la quatrième pluralité de transistors montés en cascade (76a, 76b, 77a, 77b),
un circuit de contre-réaction connecté entre la borne de sortie (99) de l'amplificateur et l'entrée inverseuse de l'amplificateur d'entrée (12), et
une pluralité de condensateurs (106, 108, 110) ayant des capacités différentes et étant chacun séparément connecté entre les bornes négative (46) et de référence (100) et entre les bornes positive (42) et de référence (100).
